# EUROPEAN PATENT APPLICATION

(11) **EP 4 615 186 A1**
(43) Date of publication of application: **10.09.2025**
(21) Application number: 24161377.7
(22) Date of filing: 05.03.2024
(51) Int. Cl.: H05K 9/00

(54) **EMC SHIELDING DESIGN TO MEET EMC REQUIREMENTS/SPECIFICATIONS**

(71) Applicant: Aptiv Technologies AG, 8200 Schaffhausen (CH)
(72) Inventor: JAWOR, Jaroslaw, 8200 Schaffhausen (CH); SYKUCKI, Konrad, 8200 Schaffhausen (CH)
(74) Representative: Bardehle Pagenberg Partnerschaft mbB Patentanwälte Rechtsanwälte

(57) **Abstract**

The present disclosure relates to electromagnetic compatibility (EMC) and other purposes related to flow of electric current, heat transfer, vibration transmission or other mechanical activities. An EMC shield (100) for providing electromagnetic compatibility of electronic components is provided. The EMC shield (100) comprises a first portion (102), the first portion (102) being arranged for being attached to a printed circuit board. The EMC shield (100) further comprises a second portion (110), the second portion (110) being arranged for being attached to a housing at least partially enclosing the printed circuit board. The first and second portions (102, 110) are arranged at an angle to each other. The EMC shield (100) further comprises a third portion (112) connecting the first and second portions (102, 110), and wherein the third portion (112) is a bend portion between the first portion (102) and the second portion (110).

## Description

### 1. Field of the invention

The present disclosure generally relates to electromagnetic compatibility (EMC) and other purposes related to flow of electric current, heat transfer, vibration transmission or other mechanical activities.

### 2. Prior art

In general, electric and/or magnetic field generated by electronic component(s) may be required to stay confined within a restricted space surrounding such component(s). Also, such fields may be required not to enter the electronic component(s) from outside. The rationale for the above requirements includes avoiding mutual interference among electronic components/devices/units and/or ensuring compliance with regulatory (or customer) specifications. In general, various measures are known to facilitate the electromagnetic compatibility (EMC), for example, shielding electric and/or magnetic fields. Shielding aims at improving EMC properties for electrical components. It may be generally used with any electrical component having high exposure to and/or high emissions of electromagnetic radiation. Shielding measures include placing electronic components within a shield which is formed from sheet metal. However, the design of such known shields may not meet regulatory (or customer) specifications and/or may not be well suited for interfacing with the printed circuit board (PCB) and/or the housing (or stamping cover, or other mechanical object having characteristics of conducting electric current) of the device/unit comprising the electronic component(s) to be protected.

The object of the disclosed subject matter is to provide an enhanced EMC shield for providing electromagnetic compatibility of electronic components which at least partially overcomes disadvantages attributable to prior art EMC shields. The disclosed subject matter may also enhance heat transfer between mechanical and electronic elements, and may also enhance vibrations and electrical contact.

### 3. Summary of the invention

The above-mentioned object is realized by an EMC shield according to claim 1 and an electronic unit according to claim 11.

Particularly, the above-mentioned object is realized by an EMC shield for providing electromagnetic compatibility of electronic components. The EMC shield comprises a first portion being arranged for being attached to a printed circuit board (PCB) and a second portion being arranged for being attached (e.g., directly or indirectly) to a housing at least partially enclosing the PCB. The first and second portions are arranged at an angle to each other which excludes an angle of substantially 0 degree. This means that the first and second portions are not entirely comprised within a single plane. The EMC shield further comprises a third portion connecting the first and second portions which is a bend portion between the first portion and a second portion. Each portion may be formed as one or more walls, a mesh, a foam, or the like. As a result, the first portion may be attached (e.g., soldered, press-fitted, or the like) substantially perpendicular to the PCB and the second portion may be attached at an angle different than perpendicularly to the housing enclosing the PCB. The use of the bend portion may (relative to the use of a straight EMC shield) advantageously compensate manufacturing tolerances, such as the height of the EMC shield, and effectuate advantageous contact (e.g., planar contact, not edge contact; electric and/or mechanical, and/or thermal contact) between the second portion of the EMC shield and the housing (e.g., a cover of the housing). In addition, the use of the bend portion may advantageously enable spring properties of the EMC shield (e.g., the second portion, and preferably the third portion) which may be advantageous for assembling/closing the housing.

In an aspect of the present disclosure, the first portion is substantially perpendicular to the second portion. This may advantageously provide a larger area of contact (e.g., electric and/or thermal contact) between the second portion of the EMC shield and the housing.

In a further aspect of the present disclosure, the third portion has a bending radius of at least 0,5 mm, preferably at least 1,0 mm and more preferably between 1,0 mm and 3,0 mm. As a result, the third portion of the EMC shield may advantageously provide a transition region between the first and second portions. In addition, the second portion (and preferably also the third portion) is arranged such that the second portion has spring properties which may be advantageous for assembling/closing the housing.

In a further aspect of the present disclosure, the first portion is formed as one or more walls and the second portion is formed as one or more walls. This may advantageously shield electric and/or magnetic fields, and/or provide stiffness of the first and second portions. Preferably the first portion is formed as a plurality of walls forming a prism having inside an opening. As a result, one or more electronic components may be advantageously located within the prism and hence may obtain EMC shielding. Further preferably the prism has a substantially rectangular base. As a result, typical electronic components having rectangular footprint, such as integrated circuits (ICs), processors, or the like, maybe advantageously located within the prism. Alternatively, the prism may have a substantially circular base. As a result, electronic components having circular footprint, such as coils, or the like, may be advantageously located within the prism.

In a further aspect of the present disclosure, the third portion is bent outwards the first portion such that the second portion forms a flange for being attached to the housing. As a result, the opening inside the prism may be advantageously uniform along the height of the EMC shield such that, for example, a thermal conductor (e.g., a pedestal of the housing) may be advantageously located within the prism and to be (thermally) attached to the electronic component located within the EMC shield. In addition, the flange may advantageously establish contact (e.g., planar contact) between the second portion of the EMC shield and the housing (e.g., the cover).

In a further aspect of the present disclosure, the first portion comprises a plurality of mounting tabs arranged along a first edge. The first edge may be the edge located adjacent to the PCB when the EMC shield is mounted on the PCB. The mounting tabs may advantageously facilitate mounting (e.g., soldering) the EMC shield to the PCB. The shape and dimensions of the mounting tabs may be selected to advantageously distribute strain and avoid cracking (e.g., of the solder). Preferably, the plurality of mounting tabs is arranged equidistantly along the first edge. This may advantageously result in uniform distribution of strain resulting from mounting the EMC shield to the PCB. Further preferably, each mounting tab is substantially rectangular. This may advantageously facilitate manufacturing the EMC shield and soldering it to the PCB.

In a further aspect of the present disclosure, the second portion (and preferably also the third portion) comprises a plurality of recesses arranged along a second edge. The second edge may be the edge opposite to the first edge (i.e., the edge located adjacent to the PCB when the EMC shield is mounted on the PCB). This may advantageously facilitate bending the third portion, facilitate spring properties of the EMC shield (e.g., the second portion, and preferably also the third portion) and may be advantageous for assembling/closing the housing. The shape and dimensions of the recesses may be selected to advantageously facilitate bending the third portion and may be advantageous for assembling/closing the housing. Preferably the recesses are arranged equidistantly. This may advantageously result in uniform distribution of strain resulting from attaching the second portion of the EMC shield to the housing. Further preferably, each recess is substantially rectangular or U-shaped. This may advantageously facilitate manufacturing the EMC shield.

In a further aspect of the present disclosure, each recess has an axis in a plane being substantially parallel to an axis of the prism such that the second portion has the spring properties in a direction substantially parallel to the axis of the prism. This arrangement of the recesses advantageously enables establishing the spring properties in a direction substantially perpendicular to the housing (e.g., the cover).

In a further aspect of the present disclosure, the EMC shield is formed from stamped and bent sheet metal. As a result, manufacturing of the EMC shield may be advantageously facilitated.

In a further aspect of the present disclosure, the EMC shield is integrally formed from one piece of stamped and bent sheet metal. As a result, ease of manufacturing and assembling of the EMC shield may be advantageously achieved. The single sheet metal is preferably welded or pressed at at least two edges to form a closed polygon. As a result, a form of the EMC shield which is ready to be mounted on the PCB may be advantageously achieved.

Further particularly, the above-mentioned object is realized by an electronic unit comprising a printed circuit board (PCB), a housing (or another metallic device) at least partially enclosing the PCB, and the above-described EMC shield in which the first portion is attached (e.g., soldered) to the PCB and the second portion is attached (e.g., directly or by using intervening elements) to the housing such that EMC shielding and thermal conductivity are ensured. As a result, the above-described EMC shield may be advantageously applied in the electronic unit.

In an aspect of the present disclosure, the second portion is attached to the housing via one or more pads made of a material being one or more compressible, thermally conductive, electrically conductive. A compressible material may advantageously compensate manufacturing tolerances and may absorb relative movement between the second portion of the EMC shield and the housing (avoid rattle) caused, for example, by vibrations of the electronic unit. A thermally conductive material may advantageously facilitate heat conduction from the PCB to the housing of the electronic unit. Such pads are often referred to as thermal pads and may comprise metallic particles. An electrically conductive material may advantageously further enhance EMC shielding by providing a conductive path between the PCB and the housing of the electronic unit.

In a further aspect of the present disclosure, each pad is either glued on the housing or is compressed between a corresponding second portion and the housing with no glue being used. As a result, ease of assembling of the electronic unit comprising the EMC shield may be advantageously achieved.

In a further aspect of the present disclosure, the second portion is directly attached to the housing. This may advantageously provide function of pressing the PCB by the housing and facilitate heat conduction from the PCB to the housing of the electronic unit.

In a further aspect of the present disclosure, the electronic unit further comprises an integrated circuit (IC) component mounted on the PCB and the EMC shield surrounds the IC component. As a result, electromagnetic compatibility of the IC component may be advantageously provided. Preferably the housing comprises a pedestal (thermally) attached to the IC component and the pedestal is at least partially located in at last a part of the opening. This may advantageously provide head conduction from the IC component via the pedestal to the housing (or another mechanical object, e.g., cover) of the electronic unit.

### 4. Brief description of the drawings

In the following, various aspects of the disclosed subject matter are described in detail with reference to the accompanying figures, in which:
- Fig. 1: shows a three-dimensional view of an embodiment of an EMC shield;
- Fig. 2: shows a three-dimensional view of an embodiment of a printed circuit board;
- Fig. 3: shows a three-dimensional view of an embodiment of an electronic unit;
- Fig. 4: shows a three-dimensional view of another embodiment of a printed circuit board;
- Fig. 5: shows a three-dimensional view of another embodiment of an electronic unit;
- Fig. 6: shows another three-dimensional view of the other embodiment of an electronic unit.

### 5. Detailed description

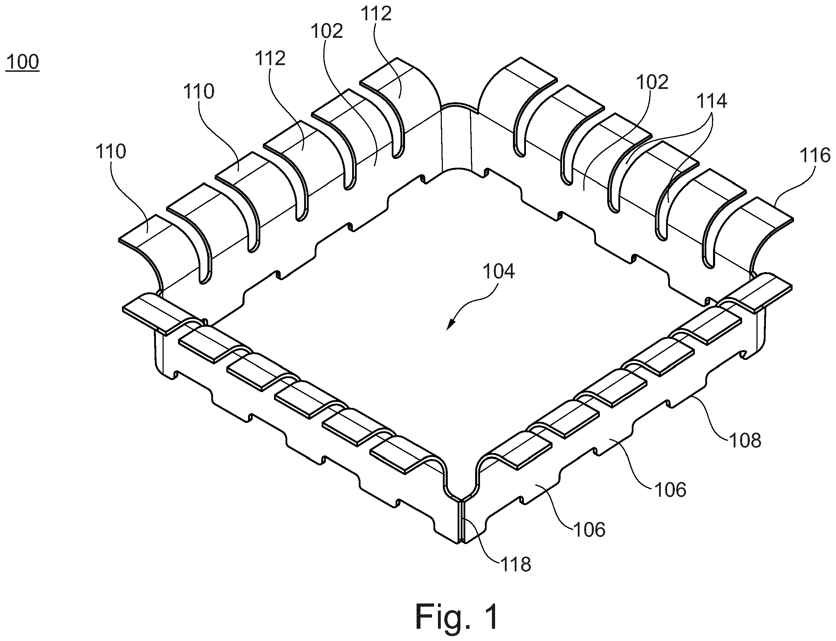

Fig. 1 shows - in a three-dimensional view - an EMC shield 100 according to an embodiment of the present disclosure. The EMC shield 100 comprises a first portion 102. The first portion 102 is arranged for being attached to a printed circuit board (PCB) (not shown). The first portion 102 is formed as 4 walls forming a prism having inside an opening 104. The first portion 102 comprises a plurality of mounting tabs 106 arranged along a first edge 108. The first edge 108 is located adjacent to the PCB when the EMC shield 100 is mounted on the PCB. Each mounting tab 106 is substantially rectangular with rounded edges. The mounting tabs 106 are arranged substantially equidistantly. The mounting tabs 106 may be arranged to be solderable to the PCB such that the first portion 102 is substantially perpendicular to the PCB.

The EMC shield 100 further comprises a second portion 110. The second portion 110 is arranged for being attached to a housing (not shown) in which the PCB is (at least partially) enclosed. The second portion 110 is formed as individual walls, each of which is substantially perpendicular to the first portion 102. The individual walls forming the second portion 110 are arranged to form a flange for being attached to the housing.

The EMC shield 100 further comprises a third portion 112. The third portion 112 is located between the first portion 102 and the second portion 110, and connects the first portion 102 and the second portion 110. The third portion 112 is bent outwards the first portion 102 such that the second portion 110 forms the flange. The third portion 112 has a bending radius of approx. 1,5 mm. The second portion 110, the third portion 112, and the first portion 102 comprise a plurality of recesses 114. The recesses 114 are arranged along a second edge 116 and are substantially rectangular with rounded edges.

The bending of the third portion 112 and the recesses 114 provide spring properties to the second portion 110 and the third portion 112. More specifically, the spring properties are in a direction which is substantially parallel to the axis of the prism. In general, the spring properties are determined (among others) by the shape and dimensions of the bending of the third portion 112 and of the recesses 114.

The EMC shield 100 is formed from a single piece of stamped and bent sheet metal. The single sheet metal is welded at edges 118 to form a closed polygon and consequently a prism. The skilled person recognizes that the EMC shield 100 may also be formed from a plurality of pieces of stamped and bent sheet metal which are then connected together (e.g., welded, pressed, glued, soldered, connected by hardfacing, or the like) to form a closed polygon and consequently a prism.

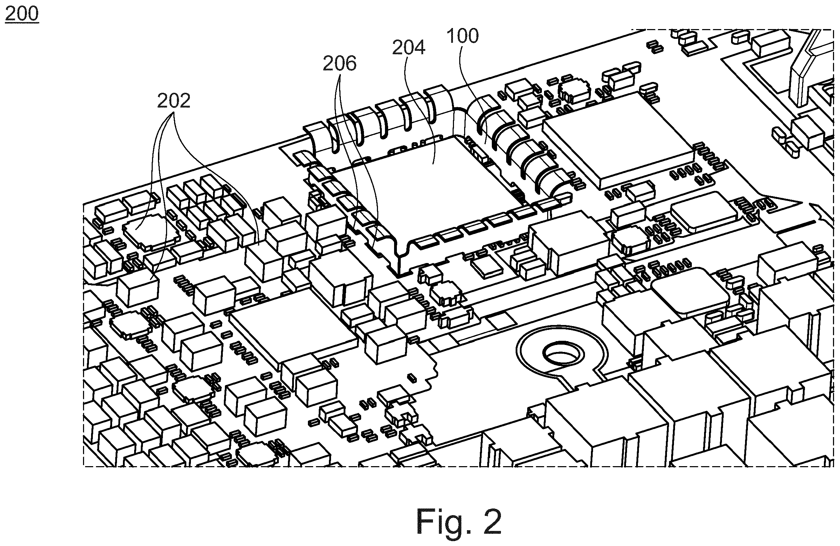

Fig. 2 shows - in a three-dimensional view - a section of a printed circuit board 200 according to an embodiment of the present disclosure. The printed circuit board 200 comprises a plurality of electronic components 202 including an integrated circuit (IC) component 204 which are mounted thereon. The IC component 204 may be a microprocessor, a microcontroller, or the like. Various techniques to design and manufacture a printed circuit board are generally known to the skilled person.

Certain amount of electric and/or magnetic field generated by the IC component 204 is required to stay confined within a restricted space surrounding the IC component 204. Further, only certain amount of electric and/or magnetic field is allowed to enter the IC component 204 from outside. The limits for such electric and/magnetic fields are defined in regulatory (or customer) specifications.

To facilitate satisfying the above-mentioned limits on electric and/or magnetic field, the printed circuit board 200 comprises the above-described EMC shield 100 (explained in conjunction with Fig. 1). The EMC shield 100 is mounted to the printed circuit board 200 by soldering the mounting taps 106 to the printed circuit board 200 at a plurality of soldering locations 206.

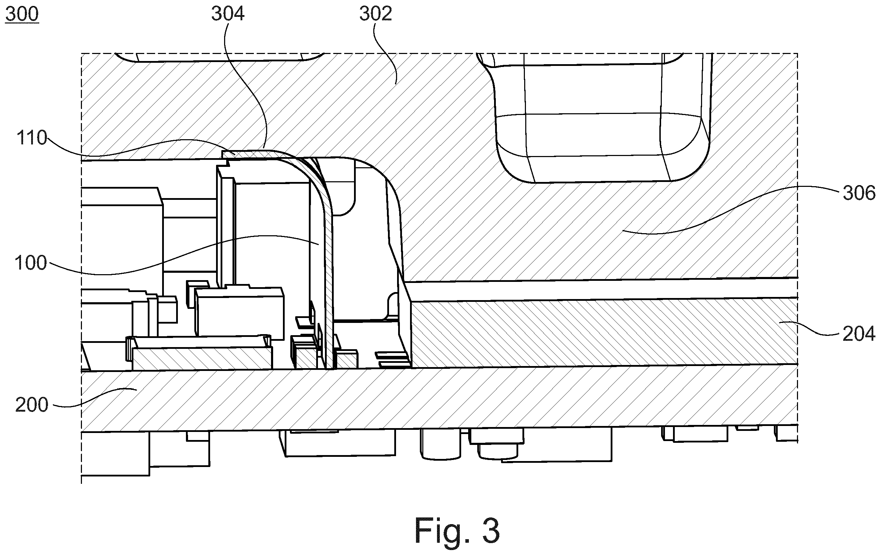

Fig. 3 shows - in a three-dimensional view - a section of an electronic unit 300 according to an embodiment of the present disclosure. The electronic unit 300 comprises the printed circuit board 200 (explained in conjunction with Fig. 2), a housing 302 which at least partially encloses the printed circuit board 200, and the EMC shield 100 (explained in conjunction with Fig. 1). Various techniques to design and manufacture a housing are generally known to the skilled person. The housing 302 is made of die cast aluminum. However, other materials (e.g., magnesium, zinc) are envisaged.

The EMC shield 100 is directly attached to the housing 302 at a contact location 304.

The second portion 110 of the EMC shield 100 is substantially parallel to a cover of the housing 302 of the electronic unit 300. The direct contact between the EMC shield 100 and the housing 302 (via the second portion 110 at the contact location 304) facilitates heat conduction from the printed circuit board 200 to the housing 302. The direct contact between the EMC shield 100 and the housing 302 of the electronic unit 300 also enhances EMC shielding by providing a conductive path between the printed circuit board 200 and the housing 302.

The electronic unit 300 comprises the IC component 204 (explained in conjunction with Fig. 2) located on the printed circuit board 200. A pedestal 306 (which is an element of the housing 302 intended as a heat conductor) is thermally conductively attached to the top housing of the IC component 204. The opening 104 within the EMC shield 100 facilitates attaching the pedestal 306 to the IC component 204.

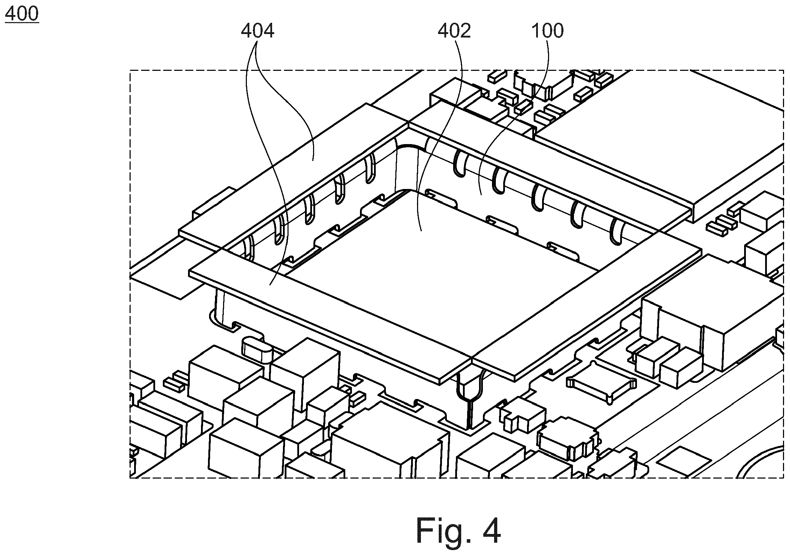

Fig. 4 shows - in a three-dimensional view - a section of a printed circuit board 400 according to an embodiment of the present disclosure. Similar as the printed circuit board 200, also the printed circuit board 400 comprises a plurality of electronic components including an integrated circuit (IC) component 402 mounted thereon. The IC component 402 may be the same as the IC component 204.

As at the printed circuit board 200, the above-described EMC shield is mounted on the printed circuit board 400 to facilitate satisfying specifications for electric and/or magnetic field radiated from the IC component 402 and/or entering the IC component 402 from outside.

Unlike at the printed circuit board 200, at the printed circuit board 400, the EMC shield 100, is not directly attached to a housing (not shown) in which the printed circuit board 400 is (at least partially) enclosed. Rather, the EMC shield 100 is attached to the housing via a plurality of pads 404.

The pads 404 provide multi-fold functionalities: In some aspects, the pads 404 may be compressible. Compressible pads compensate manufacturing tolerances of the printed circuit board 400, the EMC shield 100, the housing, or the like. Further, compressible pads absorb relative movement between the second portion 110 of the EMC shield 100 and the housing. In other words, compressible pads facilitate handing rattle caused, for example, by vibrations. In other aspects, the pads may be thermally conductive. Such pads are often referred to as thermal pads and may comprise metallic particles. Thermally conductive pads facilitate heat conduction from the printed circuit board 400 to the housing. In still other aspects, the pads may be electrically conductive.

Electrically conductive pads further enhance (relative to the EMC shield 100 taken on its own) EMC shielding by providing a conductive path between the printed circuit board 400 and the housing. The above-explained multi-fold functionalities of the pads 404 may be advantageously combined with each other.

Similar as at the printed circuit board 200, also at the printed circuit board 400, the EMC shield 100 is mounted to the printed circuit board 400 by soldering the mounting taps to the printed circuit board 400 at a plurality of soldering locations.

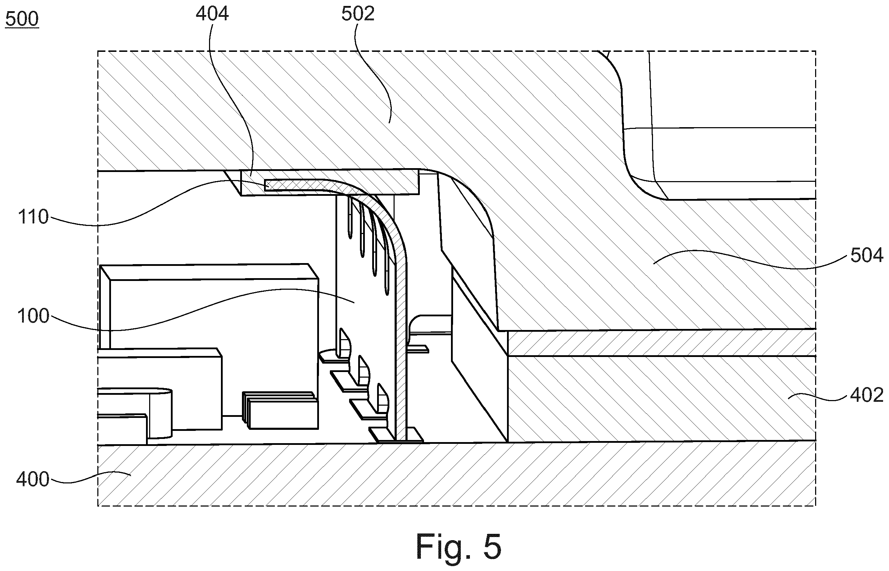

Fig. 5 shows - in a three-dimensional view - a section of an electronic unit 500 according to an embodiment of the present disclosure. The electronic unit 500 comprises the printed circuit board 400 (explained in conjunction with Fig. 4), a housing 502 which at least partially encloses the printed circuit board 400, the EMC shield 100 (explained in conjunction with Fig. 1) and the pads 404 (explained in conjunction with Fig. 4). The housing 502 is made of die cast aluminum. However, other materials are envisaged.

The EMC shield 100 is attached to the housing 502 via the pads 404. The second portion 110 of the EMC shield 100 may be arranged substantially parallel to a cover of the housing 502 or may be slightly angulated. Tolerances with respect to distance and/or angle between the second portion 110 and the housing 502 are compensated by the pads 404. In addition, in view of the multi-fold functionalities of the pads 404, the pads 404 may absorb relative movement between the second portion 110 of the EMC shield 100 and the housing 502, may facilitate heat conduction from the printed circuit board 400 to the housing 502, and/or may enhance EMC shielding by providing a conductive path between the printed circuit board 400 and the housing 502 of the electronic unit 500.

Similar as at the electronic unit 300, also the electronic unit 500 comprises the IC component 402 located at the printed circuit board 400. A pedestal 504 (which is an element of the housing 502 intended as a heat conductor) is thermally conductively attached to the top of the housing of the IC component 402. The opening 104 with the EMC shield facilitates attaching the pedestal 504 to the IC component 402.

In some aspects of the present disclosure, the pads 404 are glued on the housing 502 prior to final assembling (closing) the housing 502. In other aspects, the pads are arranged (e.g., deposited) onto the second portion 110 of the EMC shield 100 prior to final assembling (closing) the housing 502. In this aspect, upon the assembling, the pads 404 are compressed between the second portion 110 and the housing 502 with no glue (or the like) being used.

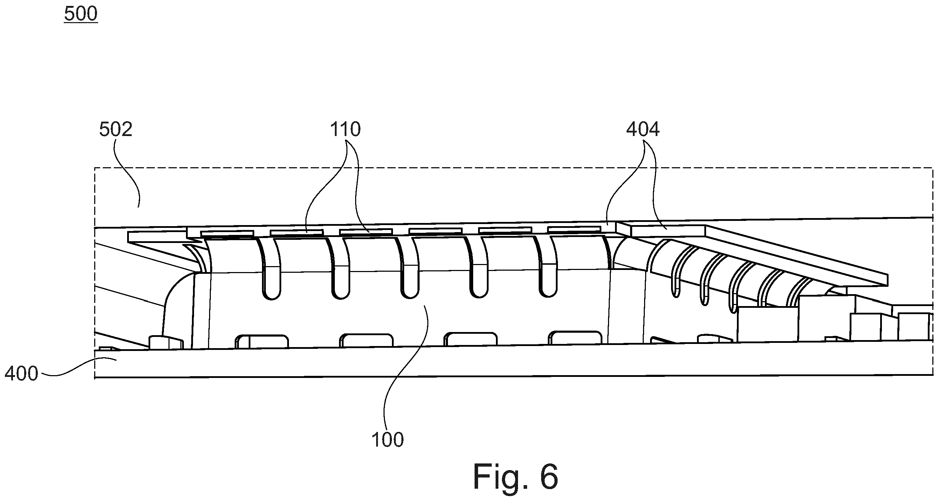

Fig. 6 shows - in a three-dimensional view - another section of the electronic unit 500 according to an embodiment of the present disclosure. The EMC shield 100 is soldered to the printed circuit board 400. The pads 404 are placed and compressed between the second portion 110 of the EMC shield 100 and the housing 502 of the electronic unit 500 at assembling/closing the housing 502.

### List of reference signs:

- 100: EMC shield
- 102: first portion
- 104: opening
- 106: mounting tabs
- 108: first edge
- 110: second portion
- 112: third portion
- 114: recesses
- 116: second edge

- 200: printed circuit board
- 202: electronic components
- 204: integrated circuit component
- 206: soldering locations

- 300: electronic unit
- 302: housing
- 304: contact location
- 306: pedestal
- 400: printed circuit board
- 402: integrated circuit component
- 404: pads

- 500: electronic unit
- 502: housing
- 504: pedestal

## Claims

1. An EMC shield (100) for providing electromagnetic compatibility of electronic components, the EMC shield (100) comprising:
a. a first portion (102), the first portion (102) being arranged for being attached to a printed circuit board;
b. a second portion (110), the second portion (110) being arranged for being attached to a housing at least partially enclosing the printed circuit board;
**characterized in that**
c. the first and second portions (102, 110) are arranged at an angle to each other,
d. wherein the EMC shield (100) further comprises a third portion (112) connecting the first and second portions (102, 110), and wherein the third portion (112) is a bend portion between the first portion (102) and the second portion (110).

2. The EMC shield (100) of claim 1, wherein the first portion (102) is substantially perpendicular to the second portion (110).

3. The EMC shield (100) of any of the preceding claims, wherein the third portion (112) has a bending radius of at least 0,5 mm, preferably at least 1,0 mm and more preferably between 1,0 mm and 3,0 mm, and preferably wherein the second portion (110), and preferably also the third portion (112), is arranged such that the second portion (110) has spring properties.

4. The EMC shield (100) of any of the preceding claims, wherein the first portion (102) is formed as one or more walls and the second portion (110) is formed as one or more walls, and preferably wherein the first portion (102) is formed as a plurality of walls forming a prism having inside an opening (104), and further preferably wherein the prism has a substantially rectangular base or a substantially circular base.

5. The EMC shield (100) of claim 4, wherein the third portion (112) is bent outwards the first portion (102) such that the second portion (110) forms a flange arranged for being attached to the housing.

6. The EMC shield (100) of any of the preceding claims, wherein the first portion (102) comprises a plurality of mounting tabs (106) arranged along a first edge (108), and preferably wherein the plurality of mounting tabs (106) is arranged equidistantly, and further preferably wherein each mounting tab (106) is substantially rectangular.

7. The EMC shield (100) of any of the preceding claims, wherein the second portion (110), and preferably also the third portion (112), comprises a plurality of recesses (114) arranged along a second edge (116), and preferably wherein the recesses (114) are arranged equidistantly, and further preferably wherein each recess (114) is substantially rectangular or U-shaped.

8. The EMC shield (100) of claim 7, wherein each recess (114) has an axis in a plane being substantially parallel to an axis of the prism such that the second portion (110) has the spring properties in a direction substantially parallel to the axis of the prism.

9. The EMC shield (100) of any of the preceding claims, wherein the EMC shield (100) is formed from stamped and bent sheet metal.

10. The EMC shield (100) of claim 9, wherein the EMC shield (100) is integrally formed from one piece of stamped and bent sheet metal and the single sheet metal preferably is welded or pressed at at least two edges to form a closed polygon.

11. An electronic unit (300, 500) comprising:
a printed circuit board (200, 400);
a housing (302, 502) at least partially enclosing the printed circuit board (200, 400); and
the EMC shield (100) of any of the preceding claims, wherein the first portion (102) is attached, preferably soldered, to the printed circuit board (200, 400), and wherein the second portion (110) is attached to the housing (302, 502).

12. The electronic unit (500) of claim 11, wherein the second portion (110) is attached to the housing (502) via one or more pads (404) made of a material being one or more of compressible, thermally conductive, electrically conductive.

13. The electronic unit (500) of claim 12, wherein each pad (404) is either glued on the housing (502) or is compressed between a corresponding second portion (110) and the housing (502) with no glue being used.

14. The electronic unit (300) of claim 11, wherein the second portion (110) is directly attached to the housing (302).

15. The electronic unit (300, 500) of any of claims 11 to 14 further comprising:
an integrated circuit component (204, 402) mounted on the printed circuit board (200, 400);
wherein the EMC shield (100) surrounds the integrated circuit component (204, 402), and preferably wherein the housing (302, 502) comprises a pedestal (306, 504) attached to the integrated circuit component (204, 402) and the pedestal (306, 504) is at least partially located in at least a part of the opening (104).
